(19) Europäisches Patentamt
European Patent Office
Office européen des brevets

(11) **EP 3 903 966 A1**

(12) **EUROPEAN PATENT APPLICATION**
published in accordance with Art. 153(4) EPC

(43) Date of publication:
**03.11.2021 Bulletin 2021/44**

(51) Int Cl.:
***B22F 1/02*** (2006.01)

(21) Application number: **19904023.9**

(22) Date of filing: **03.12.2019**

(86) International application number:
**PCT/JP2019/047183**

(87) International publication number:
**WO 2020/137377 (02.07.2020 Gazette 2020/27)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **25.12.2018 JP 2018241510**

(71) Applicant: **Kyocera Corporation
Kyoto-shi, Kyoto 612-8501 (JP)**

(72) Inventor: **KIKUCHI, Tomonao
Kyoto-shi, Kyoto 612-8501 (JP)**

(74) Representative: **Viering, Jentschura & Partner
mbB
Patent- und Rechtsanwälte
Am Brauhaus 8
01099 Dresden (DE)**

(54) **COPPER PARTICLE, METHOD FOR PRODUCING COPPER PARTICLE, COPPER PASTE, SEMICONDUCTOR DEVICE, AND ELECTRICAL/ELECTRONIC COMPONENT**

(57)   Copper particles coated with at least one kind of a nitrogen-containing compound selected from hydrazinoethanol and a hydrazinoethanol salt.

EP 3 903 966 A1

**Description**

Technical Field

The present disclosure relates to copper particles, a method for producing the copper particles, a copper paste using the copper particles, and a semiconductor device and an electric or electronic component produced with the copper paste.

Background Art

Associated with the enhancement of the capacity and processing speed of semiconductor products and the reduction of the line width thereof, there is a demand for treatment of heat generated during the operation of the semiconductor products, and a so-called thermal management for radiating heat from the semiconductor products is receiving attention. A method of attaching a heat radiating member, such as a heat spreader and a heatsink, to a semiconductor product, and the like method are being generally employed therefor, and the thermal conductivity of the material for adhering the heat radiating member is demanded to be higher.

While depending on the configuration of the semiconductor product, a method of adhering a heat spreader directly to a semiconductor device or to a die pad portion of a lead frame having a semiconductor device adhered thereto, a method of imparting a function of a heat radiating plate to the die pad portion by exposing the die pad portion to the surface of the package, and the like method are employed for the enhancement of the efficiency of the thermal management (see, for example, PTL 1).

Furthermore, there is a case where a semiconductor device is adhered to an organic substrate or the like having a heat radiation mechanism, such as a thermal via. In this case, also, the material for adhering the semiconductor device is demanded to have a higher thermal conductivity. A white LED is being used widely as illumination equipments, such as a backlight of a color liquid crystal screen, a ceiling light, and a downlight, due to the enhancement of the luminance thereof in recent years. There are cases where the high electrical current applied to the light emitting device having increased output power causes discoloration of the adhesive for adhering the light emitting device and the substrate due to heat, light, and the like, and occurrence of time course change of the electric resistance value. In particular, in the method where the adhesion of the light emitting device and the substrate completely depends on the adhesive force of the adhesive, there is a concern that the light emitting device drops off due to the loss of the adhesion force of the bonding material under the solder melting temperature in mounting the electronic components with solder, resulting in loss of lighting. Furthermore, the enhancement of the capability of the white LED leads increase of the amount of heat generation of the light emitting device chip, and associated therewith, the structure of the LED and the members used therein are demanded to have an enhanced heat radiation capability.

In particular, a power semiconductor device using a wide band gap semiconductor, such as silicon carbide (SiC) and gallium nitride, having a less power loss is being developed actively in recent years, and a high temperature operation at 250°C or higher with a large current is becoming possible due to the high heat resistance of the device. However, for exerting the characteristics thereof, it is necessary to radiate efficiently the heat generated in the operation thereof, and a bonding material that is excellent in long-term high temperature heat resistance in addition to the electroconductivity and the thermal conductivity is demanded therefor.

As has been described above, the material used for adhering members of semiconductor devices and electric or electronic components (such as a die attach paste and a material for attaching a heat radiating member) is demanded to have a high thermal conductivity. Furthermore, the material necessarily withstands the reflow treatment in mounting the device to a substrate, and also often required to adhere over a large area, which leads the necessity of a low stress property for controlling the generation of warpage and the like due to the difference in thermal expansion coefficient among the constitutional components.

For providing an adhesive having a high thermal conductivity, in general, it is necessary to disperse a metal filler, such as silver powder or copper powder, a ceramic filler, such as aluminum nitride or boron nitride, and the like as a filler in an organic binder with high content rate (see, for example, PTL 2). However, this results in increase of the elastic modulus of the hardened product, and thereby the good thermal conductivity and the good reflow capability (i.e., the difficulty in dropping off after the reflow treatment described above) are difficult to achieve simultaneously.

As a candidate of a paste material that addresses the demands, a bonding method with silver nanoparticles, which enable bonding under a lower temperature condition than bulk silver, is receiving attention in recent years (see, for example, PTL 3).

While silver particles have a considerably good electroconductivity, substitution thereof with another metal is being considered due to the expensiveness thereof and a concern of migration. Under the circumstances, copper particles, which are inexpensive as compared to silver particles and have a migration resistance, are receiving attention currently.

As a known method for forming a metal pattern, a so-called printed electronics method has been known, which includes a step of applying an electroconductive material, such as a paste or an ink, containing metal particles, such as gold, silver, or copper, to a substrate by such a method as screen printing or ink-jet printing, and a conductor forming step of fusing the metal particles by heating the electroconductive material applied to the substrate, so as to exhibit electroconductivity (see, for example, PTL 4).

Citation List

Patent Literatures

PTL 1: JP 2006-086273 A
PTL 2: JP 2005-113059 A
PTL 3: JP 2011-240406 A
PTL 4: JP 2016-160456 A

Summary of Invention

Technical Problem

The metal pattern that is formed by the printed electronics method tends to have a higher volume resistivity and a lower adhesive force to the substrate than a metal pattern that is formed by the photolithography method. Accordingly, there is a demand of a paste that can be sintered at a low temperature and has a low resistance. However, the decrease of the sintering temperature leads a concern of decrease in storage stability.

The application to a metal pattern requires a higher migration resistance than the application to bonding. Accordingly, there is a demand of an electroconductive paste using copper particles having a better migration resistance than silver particles.

However, the bonding with copper nanoparticles requires a high temperature of 300°C for exhibiting electroconductivity, and there are cases where the handling and treatment thereof become complicated due to the small particle diameter and the difficulty in controlling the oxidation thereof. Furthermore, the copper particles have been sintered necessarily in a reducing atmosphere from the standpoint of the removal of the surface oxidized film.

The copper nanoparticles for wiring, which are particularly undergoing research and development, can be sintered at a relatively low temperature, but in the use thereof for bonding, a difference in sintering rate and sintering degree occurs between the interior portion and the fillet portion of the bonding layer, which makes it difficult to provide a bonded article having high reliability.

The application to a metal pattern requires the migration resistance, and therefore there is a tendency that an electroconductive paste using copper particles is strongly demanded as compared to silver particles. However, the ordinary copper paste is difficult to provide a low resistance, and accordingly there is a demand of a copper paste for printing that can be sintered at a low temperature and can provide a low resistance.

The electroconductive paste that is used as a paste for printing in the printed electronics or the like is also demanded to provide an electroconductive layer having a low resistance, in view of the recent tendency of decreasing the wiring pitch.

The present disclosure has been made under the actual situation described above, and is to provide copper particles that are excellent in oxidation resistance, can be sintered at a low temperature, can provide uniformity in sintering rate and sintering degree between the interior portion and the fillet portion of the bonding layer, and have a good coating film formability and good bonding characteristics, a method for producing the copper particles, a copper paste containing copper particles produced by the production method, and a semiconductor device and an electric or electronic component having excellent reliability produced with the copper paste.

Solution to Problem

The present disclosure relates to the following.

[1] Copper particles coated with at least one kind of a nitrogen-containing compound selected from hydrazinoethanol and a hydrazinoethanol salt.

[2] A method for producing the copper particles according to the item [1], including reducing a copper compound (A) with at least one kind of a nitrogen-containing compound selected from hydrazinoethanol and a hydrazinoethanol salt (B).

[3] The method for producing the copper particles according to the item [2], the method further includes adding hydrazine monohydrate (C).

[4] A copper paste containing the copper particles according to the item [1].

[5] A semiconductor device bonded with the copper paste according to the item [4].

[6] An electric or electronic component bonded with the copper paste according to the item [4].

Advantageous Effects of Invention

According to the present disclosure, copper particles that are excellent in oxidation resistance, can be sintered at a low temperature, can provide uniformity in sintering rate and sintering degree between the interior portion and the fillet portion of the bonding layer, and have a good coating film formability and good bonding characteristics, a method for producing the copper particles, a copper paste containing copper particles produced by the production method, and a semiconductor device and an electric or electronic component having excellent reliability produced with the copper paste can be provided.

Description of Embodiments

The present disclosure will be explained in detail with reference to one embodiment below.

<Copper Particles>

The copper particles of the present embodiment are coated with at least one kind of a nitrogen-containing compound selected from hydrazinoethanol and a hydrazinoethanol salt.

The copper particles constituting the base material of the aforementioned copper particles are derived from a copper compound. The copper compound is not particularly limited, as far as the compound contains copper atoms. Examples of the copper compound include a copper carboxylate, a copper oxide, a copper hydroxide, and a copper nitride. The copper compound may be a copper carboxylate from the standpoint of the uniformity in reaction. The compounds may be used alone or as a combination of two or more kinds thereof.

Examples of the copper carboxylate include anhydrates and hydrates of copper(I) formate, copper(I) acetate, copper(I) propionate, copper(I) butyrate, copper(I) valerate, copper(I) caproate, copper(I) caprylate, copper(I) caprate, copper(II) formate, copper(II) acetate, copper(II) propionate, copper(II) butyrate, copper(II) valerate, copper(II) caproate, copper(II) caprylate, copper(II) caprate, and copper(II) citrate. The copper carboxylate may be copper(II) acetate monohydrate from the standpoint of the productivity and the availability. These compounds may be used alone or as a combination of two or more kinds thereof.

The copper carboxylate used may be a commercially available product or one obtained through synthesis.

The copper carboxylate may be synthesized by a known method, and for example, may be obtained by mixing and heating copper(II) hydroxide and a carboxylic acid compound.

Examples of the copper oxide include copper(II) oxide and copper(I) oxide, and the copper oxide may be copper(I) oxide from the standpoint of the productivity. Examples of the copper hydroxide include copper(II) hydroxide and copper(I) hydroxide.

These compounds may be used alone or as a combination of two or more kinds thereof.

The hydrazinoethanol and the hydrazinoethanol salt used in the present embodiment stabilize the copper particles through adsorption on the surface of the copper particles. The hydrazinoethanol and the hydrazinoethanol salt have, in heating, functions including the desorption through the thermal decomposition mechanism and the reduction of the oxidized layer of the copper particles, resulting in significant increase of the sinterability. The hydrazinoethanol salt may be used from the standpoint of the oxidation resistance.

The hydrazinoethanol salt includes an organic salt type and an inorganic salt type, and may be an organic salt type. Examples of the organic salt type include an organic carboxylate, an organic phosphate, and an organic sulfonate. The organic salt type may be an organic carboxylate from the standpoint of the solubility in synthesis.

Examples of the organic carboxylate include hydrazinoethanol acetate, hydrazinoethanol propionate, hydrazinoethanol butyrate, hydrazinoethanol valerate, hydrazinoethanol caproate, hydrazinoethanol heptanoate, hydrazinoethanol caprylate, hydrazinoethanol nonanoate, hydrazinoethanol caprate, hydrazinoethanol stearate, and hydrazinoethanol oleate. Among these, the organic carboxylate may be hydrazinoethanol acetate, hydrazinoethanol propionate, hydrazinoethanol butyrate, hydrazinoethanol valerate, hydrazinoethanol caproate, hydrazinoethanol heptanoate, hydrazinoethanol caprylate, or hydrazinoethanol nonanoate from the standpoint of the sinterability, and may be hydrazinoethanol valerate, hydrazinoethanol caproate, hydrazinoethanol heptanoate, hydrazinoethanol caprylate, or hydrazinoethanol nonanoate from the standpoint of the oxidation resistance. These compounds may be used alone or as a combination of two or more kinds thereof.

The hydrazinoethanol salt used may be synthesized and isolated in advance, or may be obtained through in-situ synthesis in the production of the copper particles.

The average particle diameter of the copper particles in the present embodiment may be 20 to 700 nm, may be 50 to 400 nm, or may be 70 to 300 nm, from the standpoint of the denseness of the bonding layer.

The average particle diameter of the copper particles shown above is a number average particle diameter, which may be obtained by number-averaging the particle diameters of 10 or more particles measured through scanning electron microscope (SEM) observation. Specifically, the average particle diameter may be obtained by the method shown in the examples.

<Method for producing Copper Particles>

The method for producing copper particles of the present embodiment includes reducing a copper compound (A) with at least one kind of a nitrogen-containing compound selected from hydrazinoethanol and a hydrazinoethanol salt (B).

The at least one kind of a nitrogen-containing compound selected from hydrazinoethanol and a hydrazinoethanol salt (B) reduces the copper compound (A) in a relatively high temperature region around 100°C. The copper particles of the present embodiment are obtained by reducing the copper compound (A) with the at least one kind of a nitrogen-containing compound selected from hydrazinoethanol and a hydrazinoethanol salt (B) at around 100°C. The surface of the copper particles thus obtained is coated with the at least one kind of a nitrogen-containing compound selected from hydrazinoethanol and a hydrazinoethanol salt (B).

The copper compound (A) and the at least one kind of a nitrogen-containing compound selected from hydrazinoethanol and a hydrazinoethanol salt (B) used herein may be the compounds exemplified in the section <Copper Particles> respectively.

The method for producing copper particles of the present embodiment may further include adding hydrazine monohydrate (C) from the standpoint of the further enhancement of the sinterability. In the case where the copper compound (A) is reduced with the at least one kind of a nitrogen-containing compound selected from hydrazinoethanol and a hydrazinoethanol salt (B), and an amine compound and the like are formed as by-products, there is a concern that the copper particles are coated with the amine compound and the like, so as to hinder the sintering.

On the other hand, the hydrazine monohydrate (C) has a reducing capability at room temperature (25°C). Accordingly, by using the reducing capability of the hydrazine monohydrate (C) in a low temperature region around room temperature, the reduction reaction with the hydrazine monohydrate (C) is made to proceed in priority without competition against the reaction with the at least one kind of a nitrogen-containing compound selected from hydrazinoethanol and a hydrazinoethanol salt (B), and thereby the copper particles further excellent in sinterability can be obtained.

In the method for producing copper particles of the present embodiment, an alkylamine may be used. The use of an alkylamine can enhance the dispersibility of the copper particles produced.

The alkylamine is not particularly limited in the structure thereof, as far as the alkylamine is an amine compound that has an aliphatic hydrocarbon group, such as an alkyl group, as a group bonded to the amino group, and examples thereof include an alkylmonoamine having one amino group and an alkyldiamine having two amino groups. The alkyl group may further have a substituent.

Specifically, examples of the alkylmonoamine include dipropylamine, butylamine, dibutylamine, hexylamine, cyclohexylamine, heptylamine, octylamine, nonylamine, decylamine, 3-aminopropyltriethoxysilane, dodecylamine, and oleylamine. Examples of the alkyldiamine include ethylenediamine, N,N-dimethylethylenediamine, N,N'-dimethylethylenediamine, N,N-diethylethylenediamine, N,N'-diethylethylenediamine, 1,3-propanediamine, 2,2-dimethyl-1,3-propanediamine, N,N-dimethyl-1,3-diaminopropane, N,N'-dimethyl-1,3-diaminopropane, N,N-diethyl-1,3-diaminopropane, 1,4-diaminobutane, 1,5-diamino-2-methylpentane, 1,6-diaminohexane, N,N'-dimethyl-1,6-diaminohexane, 1,7-diaminoheptane, and 1,8-diaminooctane. These compounds may be used alone or as a combination of two or more kinds thereof.

In the method for producing copper particles of the present embodiment, an aliphatic carboxylic acid may be used. The use of an aliphatic carboxylic acid can enhance the dispersibility of the copper particles produced.

Examples of the aliphatic carboxylic acid include a monocarboxylic acid, such as formic acid, acetic acid, propionic acid, butyric acid, valeric acid, hexanoic acid, caprylic acid, octylic acid, nonanoic acid, capric acid, oleic acid, stearic acid, and isostearic acid; a dicarboxylic acid, such as oxalic acid, malonic acid, succinic acid, glutaric acid, adipic acid, pimelic acid, suberic acid, azelaic acid, sebacic acid, and diglycolic acid; an aromatic carboxylic acid, such as benzoic acid, phthalic acid, isophthalic acid, terephthalic acid, salicylic acid, and gallic acid; and a hydroxy acid, such as glycolic acid, lactic acid, tartronic acid, malic acid, glyceric acid, hydroxybutyric acid, tartaric acid, citric acid, and isocitric acid. These compounds may be used alone or as a combination of two or more kinds thereof.

In the method for producing copper particles of the present embodiment, an organic solvent may be used. The organic solvent used is not particularly limited, as far as the organic solvent can be used as a reaction solvent that does not impair the properties of the complex and the like formed from the mixture obtained by mixing the raw materials shown above. The organic solvent used may be an alcohol.

Since the reduction reaction of copper ion with the hydrazine monohydrate (C) is exothermic reaction, the organic solvent may be one that does not vaporize throughout the reduction reaction. The organic solvent may have a boiling point of 70°C or more, and may be constituted by carbon, hydrogen, and oxygen.

Examples of the alcohol used as the organic solvent include 1-propanol, 2-propanol, butanol, pentanol, hexanol, heptanol, octanol, ethylene glycol, 1,3-propanediol, 1,2-propanediol, butyl carbitol, butyl carbitol acetate, ethyl carbitol, ethyl carbitol acetate, diethylene glycol diethyl ether, and butyl cellosolve. These compounds may be used alone or as a combination of two or more kinds thereof.

(Formation of Mixture)

In the case where the organic solvent is used, the organic solvent is firstly housed in a reaction vessel, and in the organic solvent, the copper compound (A), the at least one kind of a nitrogen-containing compound selected from hydrazinoethanol and a hydrazinoethanol salt (B), the hydrazine monohydrate (C), and the alkylamine and the aliphatic carboxylic acid which are added depending on necessity, are mixed. The order for mixing these compounds is not particularly limited, and the aforementioned compounds may be mixed in any order.

In mixing, the amounts of the copper compound (A), the at least one kind of a nitrogen-containing compound selected from hydrazinoethanol and a hydrazinoethanol salt (B), and the hydrazine monohydrate (C) used may be 0.1 to 10 mol for the at least one kind of a nitrogen-containing compound selected from hydrazinoethanol and a hydrazinoethanol salt (B) and 0.3 to 5 mol for the hydrazine monohydrate (C), or may be 0.2 to 5 mol for the at least one kind of a nitrogen-containing compound selected from hydrazinoethanol and a hydrazinoethanol salt (B) and 0.5 to 3 mol for the hydrazine monohydrate (C), per 1 mol of the copper compound (A).

The amount of the alkylamine used may be 0.5 to 5 mol, and may be 0.5 to 3 mol, per 1 mol of the copper compound (A). The amount of the aliphatic carboxylic acid used may be 0.5 to 5 mol, and may be 0.5 to 3 mol, per 1 mol of the copper compound (A).

The amount of the organic solvent may be such an amount that enables sufficient reaction of the aforementioned components, and may be used in an amount, for example, of 50 to 2,000 mL.

(Heating Mixture)

In the heating step of the mixture, the mixture obtained by mixing above is then sufficiently heated to perform the reduction reaction of the copper compound (A). The reduction reaction of unreacted copper compound (A) can be promoted by the heating, and metallic copper can be favorably deposited and grown to form copper particles.

At this time, the at least one kind of a nitrogen-containing compound selected from hydrazinoethanol and a hydrazinoethanol salt (B) is attached to the surface of the copper particles to suppress the growth thereof, and thus has the function preventing the particles from becoming coarse.

The heating temperature in heating the mixture may be a temperature that is capable of thermally decomposing and reducing the copper compound (A) to form copper particles, and may be, for example, 25 to 150°C, or 25 to 120°C. The heating temperature may be lower than the boiling points of the components (A) to (C) and the organic solvent. In the case where the heating temperature is in the range, the copper particles can be efficiently formed, and in the case where the aliphatic carboxylic acid and/or the alkylamine are used in combination with the at least one kind of a nitrogen-containing compound selected from hydrazinoethanol and a hydrazinoethanol salt (B), the effects thereof can be exerted.

In the case where the heating temperature is less than 25°C, there is a concern that the quantitative reduction reaction of the copper compound (A) is difficult to occur, and the undecomposed copper compound remains. In the case where the heating temperature exceeds 150°C, there is a concern that the vaporization amount of the at least one kind of a nitrogen-containing compound selected from hydrazinoethanol and a hydrazinoethanol salt (B) becomes too large to make the system become non-uniform.

In the case where the copper particles of the present embodiment are produced by using the hydrazine monohydrate (C), it is possible that the first step reduction reaction is performed under condition of 0 to 80°C and 1 to 72 hours, and subsequently the second step reduction reaction is performed under condition of 60 to 150°C and 0.1 to 10 hours.

According to the procedure, the competition between the reduction reaction with the at least one kind of a nitrogen-containing compound selected from hydrazinoethanol and a hydrazinoethanol salt (B) and the reduction reaction with the hydrazine monohydrate (C) can be suppressed, and thereby the deterioration in sinterability due to the formation of by-products can be decreased.

<Copper Paste>

The copper paste of the present embodiment contains the aforementioned copper particles, and thereby can provide excellent oxidation resistance and storage stability, can be sintered at a low temperature, can provide uniformity in sintering rate and sintering degree between the interior portion and the fillet portion of the bonding layer, and can provide a hardened product having good bonding characteristics. Accordingly, the copper paste of the present embodiment can be used as a die attach paste for element adhesion and a material for attaching a heat radiating member.

The copper paste of the present embodiment may contain two or more kinds of copper particles having different average particle diameters. For example, with respect to the average particle diameter of the first copper particles, the average particle diameter of the second copper particles having a larger average particle diameter than the first copper particles may be approximately 2 to 10 times. With respect to the amount of the first copper particles mixed, the amount of the second copper particles mixed may be approximately 1.5 to 10 times.

The copper paste of the present embodiment may further contain, in addition to the aforementioned copper particles, large diameter copper particles having a larger particle diameter than the aforementioned copper particles, a thermosetting resin, an organic solvent, and additional additives. According to the configuration, the influence of the sintering shrinkage of the copper particles can be relaxed to provide a bonding layer having higher reliability.

(Large Diameter Copper Particles)

The average particle diameter of the large diameter copper particles may be more than 1 pm and 30 pm or less, and may be 2 to 20 pm.

The shape thereof is not particularly limited, and the shape thereof used may be a spherical shape, a plate shape, a flake shape, a scale shape, a dendritic shape, a rod shape, a wire shape, or the like.

The average particle diameter of the large diameter copper particles may be measured with a laser diffraction scattering particle size distribution analyzer or the like.

The large diameter copper particles used may be treated with a lubricant or a rust inhibitor. Typical examples of the treatment include a treatment with a carboxylic acid compound. Examples of the carboxylic acid compound include formic acid, acetic acid, propionic acid, butyric acid, valeric acid, caproic acid, caprylic acid, octylic acid, nonanoic acid, capric acid, palmitic acid, oleic acid, stearic acid, isostearic acid, oxalic acid, malonic acid, succinic acid, glutaric acid, adipic acid, pimelic acid, suberic acid, azelaic acid, sebacic acid, diglycolic acid, benzoic acid, phthalic acid, isophthalic acid, terephthalic acid, salicylic acid, gallic acid, glycolic acid, lactic acid, tartronic acid, malic acid, glyceric acid, hydroxybutyric acid, tartaric acid, citric acid, and isocitric acid. The carboxylic acid compound may be formic acid, acetic acid, propionic acid, butyric acid, valeric acid, caproic acid, caprylic acid, octylic acid, nonanoic acid, capric acid, palmitic acid, oleic acid, stearic acid, isostearic acid, oxalic acid, malonic acid, succinic acid, or glutaric acid from the standpoint of the sinterability with the copper particles, and may be caproic acid, caprylic acid, octylic acid, nonanoic acid, capric acid, malonic acid, succinic acid, or glutaric acid from the standpoint of the dispersibility and the oxidation resistance of the copper particles.

(Thermosetting Resin)

The thermosetting resin used is not particularly limited, as far as the thermosetting resin is those ordinarily applied to the adhesive purpose. The thermosetting resin may be a liquid resin or a resin that is in a liquid state at room temperature (25°C). Examples of the thermosetting resin include a cyanate resin, an epoxy resin, a radically polymerizable acrylic resin, and a maleimide resin. These resins may be used alone or as a combination of two or more kinds thereof.

The thermosetting resin contained in the copper paste of the present embodiment can provide an adhesive material (paste) having an appropriate viscosity. The thermosetting resin contained in the copper paste of the present embodiment can enhance the sinterability of the copper particles through the temperature rise of the copper paste with the reaction heat in hardening the resin.

The cyanate resin is a compound having an -NCO group in the molecule, and is a resin that is hardened with the formation of a three-dimensional network structure through reaction of the -NCO group under heat. Specific examples of the cyanate resin include 1,3-dicyanatobenzene, 1,4-dicyanatobenzene, 1,3,5-tricyanatobenzene, 1,3-dicyanatonaphthalene, 1,4-dicyanatonaphthalene, 1,6-dicyanatonaphthalene, 1,8-dicyanatonaphthalene, 2,6-dicyanatonaphthalene, 2,7-dicyanatonaphthalene, 1,3,6-tricyanatonaphthalene, 4,4'-dicyanatobiphenyl, bis(4-cyanatophenyl)methane, bis(3,5-dimethyl-4-cyanatophenyl)methane, 2,2-bis(4-cyanatophenyl)propane, 2,2-bis(3,5-dibromo-4-cyanatophenyl)propane, bis(4-cyanatophenyl) ether, bis(4-cyanatophenyl) thioether, bis(4-cyanatophenyl)sulfone, tris(4-cyanatophenyl) phosphite, tris(4-cyanatophenyl) phosphate, and a cyanate compound obtained through reaction of a novolac resin and a cyanogen halide. The cyanate resin used may be a prepolymer having a triazine ring formed through trimerization of the cyanate groups of these polyfunctional cyanate resins. The prepolymer may be obtained by polymerizing the polyfunctional cyanate resin monomer with a catalyst, for example, an acid, such as a mineral acid and a Lewis acid, a base, such as a sodium alcoholate, and a tertiary amine, or a salt, such as sodium carbonate.

The hardening accelerator of the cyanate resin used may be a generally known material. Examples thereof include an organic metal complex, such as zinc octylate, tin octylate, cobalt naphthenate, zinc naphthenate, and iron acetylacetonate, a metal salt, such as aluminum chloride, tin chloride, and zinc chloride, and an amine compound, such as triethylamine and dimethylbenzylamine, but are not limited thereto. These hardening accelerators may be used alone or as a mixture of two or more kinds thereof.

The epoxy resin is a compound having one or more glycidyl group in the molecule, and is a resin that is hardened with the formation of a three-dimensional network structure through reaction of the glycidyl group under heat. Two or more glycidyl groups may be contained in one molecule since the hardened product may not have sufficient characteristics in the case where only a compound having one glycidyl group is reacted. The compound having two or more glycidyl groups in one molecule may be obtained by epoxidizing a compound having two or more hydroxy groups. Examples of the compound include a bisphenol compound, such as bisphenol A, bisphenol F, and biphenol, or a derivative thereof, a diol having an alicyclic structure, such as hydrogenated bisphenol A, hydrogenated bisphenol F, hydrogenated biphenol, cyclohexanediol, cyclohexanedimethanol, and cyclohexanediethanol, or a derivative thereof, a bifunctional compound obtained by epoxidizing an aliphatic diol, such as butanediol, hexanediol, octanediol, nonanediol, and decanediol, or a derivative thereof, a trifunctional compound obtained by epoxidizing a compound having a trihydroxyphenylmethane skeleton or an aminophenol skeleton, and a polyfunctional compound obtained by epoxidizing a phenol novolac resin, a cresol novolac resin, a phenol aralkyl resin, a biphenyl aralkyl resin, a naphthol aralkyl resin, or the like, but are not limited thereto. The epoxy resin may be in a liquid state at room temperature (25°C) by itself or as a mixture, for providing a bonding paste in a paste form at room temperature (25°C). A reactive diluent may also be used in an ordinary manner. Examples of the reactive diluent include a monofunctional aromatic glycidyl ether compound, such as phenyl glycidyl ether and cresyl glycidyl ether, and an aliphatic glycidyl ether compound.

At this time, a hardening agent is used for hardening the epoxy resin, and examples of the hardening agent for the epoxy resin include an aliphatic amine, an aromatic amine, a dicyandiamide, a dihydrazide compound, an acid anhydride, and a phenol resin. Examples of the dihydrazide compound include a carboxylic acid dihydrazide, such as adipic dihydrazide, dodecanoic dihydrazide, isophthalic dihydrazide, and p-hydroxybenzoic dihydrazide, and examples of the acid anhydride include phthalic anhydride, tetrahydrophthalic anhydride, hexahydrophthalic anhydride, endomethylenetetrahydrophthalic anhydride, dodecenylsuccinic anhydride, a reaction product of maleic anhydride and polybutadiene, and a copolymer of maleic anhydride and styrene.

A hardening accelerator may be mixed for accelerating hardening, and examples of the hardening accelerator for the epoxy resin include an imidazole compound, triphenylphosphine or tetraphenylphosphine and a salt thereof, and an amine compound, such as diazabicycloundecene, and a salt thereof. The hardening accelerator may be an imidazole compound, such as 2-methylimidazole, 2-ethylimidazole, 2-phenylimidazole, 2-phenyl-4-methylimidazole, 2-phenyl-4-methyl-5-hydroxymethylimidazole, 2-phenyl-4,5-dihydroxymethylimidazole, 2-$C_{11}H_{23}$-imidazole, and an adduct of 2-methylimidazole and 2,4-diamino-6-vinyltriazine. An imidazole compound having a melting point of 180°C or more may also be used.

The radically polymerizable acrylic resin is a compound that has a (meth)acryloyl group in the molecule, and is a resin that is hardened with the formation of a three-dimensional network structure through reaction of the (meth)acryloyl group. One or more (meth)acryloyl groups may be contained in the molecule.

Examples of the acrylic resin include a (meth)acrylate having a hydroxy group, such as 2-hydroxyethyl (meth)acrylate, 2-hydroxypropyl (meth)acrylate, 3-hydroxypropyl (meth)acrylate, 2-hydroxybutyl (meth)acrylate, 3-hydroxybutyl (meth)acrylate, 4-hydroxybutyl (meth)acrylate, 1,2-cyclohexanediol mono(meth)acrylate, 1,3-cyclohexanediol mono(meth)acrylate, 1,4-cyclohexanediol mono(meth)acrylate, 1,2-cyclohexanedimethanol mono(meth)acrylate, 1,3-cyclohexanedimethanol mono(meth)acrylate, 1,4-cyclohexanedimethanol mono(meth)acrylate, 1,2-cyclohexanediethanol mono(meth)acrylate, 1,3-cyclohexanediethanol mono(meth)acrylate, 1,4-cyclohexanediethanol mono(meth)acrylate, glycerine mono(meth)acrylate, glycerin di(meth)acrylate, trimethylolpropane mono(meth)acrylate, trimethylolpropane di(meth)acrylate, pentaerythritol mono(meth)acrylate, pentaerythritol di(meth)acrylate, pentaerythritol tri(meth)acrylate, and neopentyl glycol mono(meth)acrylate, and a (meth)acrylate having a carboxy group obtained through reaction of the (meth)acrylate having a hydroxy group and a dicarboxylic acid or a derivative thereof. Examples of the dicarboxylic acid usable herein include oxalic acid, malonic acid, succinic acid, glutaric acid, adipic acid, pimelic acid, suberic acid, azelaic acid, sebacic acid, maleic acid, fumaric acid, phthalic acid, tetrahydrophthalic acid, hexahydrophthalic acid, and derivatives thereof.

Examples of the acrylic resin include a compound having a (meth)acrylic group, which is a polyether, a polyester, a polycarbonate, or a poly(meth)acrylate, a (meth)acrylate having a hydroxy group, and a (meth)acrylamide having a hydroxy group, each having a molecular weight of 100 to 10,000.

The maleimide resin is a compound having one or more maleimide group in the molecule, and is a resin that is hardened with the formation of a three-dimensional network structure through reaction of the maleimide group under heat. Examples thereof include a bismaleimide resin, such as N,N'-(4,4'-diphenylmethane)bismaleimide, bis(3-ethyl-5-methyl-4-maleimidophenyl)methane, and 2,2-bis(4-(4-maleimideophenoxy)phenyl)propane. The maleimide resin may be a compound obtained through reaction of a dimer acid diamine and maleic anhydride, or a compound obtained through reaction of a maleimidized amino acid and a polyol, such as maleimidoacetic acid, maleimidocaproic acid. The maleimidized amino acid can be obtained through reaction of maleic anhydride and aminoacetic acid or aminocaproic acid, and the polyol may be a polyether polyol, a polyester polyol, a polycarbonate polyol, or a poly(meth)acrylate polyol, and may be one containing no aromatic ring.

In the case where the thermosetting resin is mixed, the thermosetting resin may be mixed in an amount of 1 to 20 parts by mass per 100 parts by mass in total of the copper particles and the large diameter copper particles. In the case where the amount of the thermosetting resin is 1 part by mass or more, the adhesion force with the thermosetting resin can be sufficiently obtained, and in the case where the amount of the thermosetting resin is 20 parts by mass or less, the decrease of the proportion of the copper components can be controlled to secure a high thermal conductivity sufficiently, resulting in an enhanced heat radiation capability. Furthermore, the amount of the organic components can be prevented from becoming excessive, so as to suppress the deterioration with light and heat, and as a result, the lifetime of the light emitting device can be enhanced. With the range of the mixing amount, the contact among the copper particles and/or the large diameter copper particles can be controlled, and the mechanical strength of the entire adhesion layer can be readily secured by using adhesion performance of the thermosetting resin.

(Organic Solvent)

The organic solvent used may be a known solvent that functions as a reducing agent.

The organic solvent may be an alcohol, and examples thereof include an aliphatic polyhydric alcohol. Examples of the aliphatic polyhydric alcohol include a glycol compound, such as ethylene glycol, diethylene glycol, propylene glycol, dipropylene glycol, 1,4-butanediol, glycerin, and polyethylene glycol. The organic solvents may be used alone or as a combination of two or more kinds thereof.

In the case where an alcohol is used as the organic solvent, the high temperature of the heat treatment at the time of hardening (sintering) the paste increases the reduction power of the alcohol. It is considered that copper oxide partially remaining in the copper particles and metal oxides on the metal substrate (such as copper oxide) are reduced with the alcohol to become pure metals, thereby resulting in a dense hardened film having high electroconductivity and high adhesion to the substrate. Furthermore, since the paste is held between the semiconductor element and the metal substrate, the alcohol is in a partially refluxed state in the heat treatment at the time of hardening the paste, and the alcohol as the solvent is not immediately lost from the system through evaporation, but efficiently reduces the metal oxides at the paste hardening temperature, which is higher than the boiling point thereof.

The boiling point of the organic solvent specifically may be 100 to 300°C, and may be 150 to 290°C. In the case where the boiling point of the organic solvent is 100°C or more, the volatility thereof does not become too high even at ordinary temperature, and the decrease of the reduction capability due to evaporation of the dispersion medium can be suppressed to provide a stable adhesion strength. In the case where the boiling point of the organic solvent is 300°C or less, the hardened film (electroconductive film) can be readily sintered, so as to provide a film excellent in denseness. The organic solvent having a boiling point of 300°C or less can be readily removed through evaporation in sintering.

In the case where the organic solvent is mixed, the amount thereof mixed may be 7 to 20 parts by mass per 100 parts by mass in total of the copper particles and the large diameter copper particles. In the case where the amount of the organic solvent mixed is 7 parts by mass or more, the viscosity can be prevented from becoming too high, and enhanced workability can be obtained, and in the case where the amount thereof is 20 parts by mass or less, the decrease in viscosity can be controlled to control the sedimentation of the copper particles in the copper paste, resulting in increased reliability.

The copper paste of the present embodiment may contain, in addition to the aforementioned components, a hardening accelerator, a stress decreasing agent, such as rubber and silicone, a coupling agent, a defoaming agent, a surfactant, a colorant (e.g., a pigment and a dye), a polymerization inhibitor, an antioxidant, a solvent, and other various additives, which are generally added to compositions of the same kind, depending on necessity in such a range that does not impair the effects of the present embodiment. These additives may be used alone or as a combination of two or more kinds thereof.

The copper paste of the present embodiment may be prepared in such a manner that the copper particles shown above, and the large diameter copper particles, the thermosetting resin, the organic solvent, and the additives, such as the coupling agent, which are mixed depending on necessity are sufficiently mixed, then subjected to a kneading treatment with a disper, a kneader, a three-roll mill, or the like, and then defoamed.

The viscosity of the copper paste (or ink) of the present embodiment is not particularly limited, and may be selected depending on the purpose and the use method. For example, in the adhesion purpose, the viscosity may be 20 to 300 Pa·s, and may be 40 to 200 Pa·s. In the metal pattern purpose, the viscosity may be 0.1 to 30 Pa·s for a screen printing method, and may be 0.1 to 30 mPa·s for an ink-jet printing method while varying depending on the specification of the ink-jet head used. The viscosity may be controlled with the content of the solvent.

The viscosity herein is a value that is measured with an E-type viscometer (3° cone) at 25°C. The viscosity may be measured specifically by the method described in the examples.

The bonding strength of the copper paste of the present embodiment may be 25 MPa or more, and may be 30 MPa or more.

The bonding strength herein may be measured by the method described in the examples.

The copper paste of the present embodiment obtained in the aforementioned manner is excellent in thermal conductivity and heat radiation capability. Accordingly, the use thereof as a bonding material for an element and a heat radiating member to a substrate or the like can improve the radiation capability of heat in the device to the outside and can stabilize the product characteristics.

<Semiconductor Device and Electric or Electronic Component>

The semiconductor device and the electric or electronic component of the present embodiment are bonded with the copper paste described above, and thus are excellent in reliability.

The semiconductor device of the present embodiment includes a semiconductor element adhered to a substrate as an element supporting member with the copper paste described above. Accordingly, the copper paste herein is used as a die attach paste, and the semiconductor element and the substrate are adhered with the paste and fixed to each other.

The semiconductor element may be a known semiconductor element, and examples thereof include a transistor and a diode. Examples of the semiconductor element also include a light emitting element, such as LED. The kind of the light emitting element is not particularly limited, and examples thereof include ones having a nitride semiconductor, such as InN, AlN, GaN, InGaN, AlGaN, and InGaAlN, formed as a light emitting layer on a substrate by the MOBVC method or the like.

Examples of the element supporting member include supporting members formed of such materials as copper, copper plated copper, PPF (pre-plated lead flame), glass-epoxy, and ceramics.

The copper paste of the present embodiment can bond a substrate that is not subjected to a metal plating treatment. The semiconductor device obtained in this manner can have an adhesion reliability against the temperature cycle after mounting that is significantly enhanced from the ordinary products. Furthermore, the electric resistance thereof is sufficiently small and undergoes small time-dependent change, which can thus provide advantages including the small time-dependent decrease of the output power even in a long-term operation and the long lifetime.

The electric or electronic component of the present embodiment includes a heat radiating member adhered to a heat generating member with the copper paste described above. Accordingly, the copper paste herein is used as a material for attaching a heat radiating member, and the heat radiating member and the heat generating member are adhered with the copper paste and fixed to each other.

The heat generating member may be the semiconductor element described above or a member having the semiconductor element, and may be other heat generating members. Examples of the heat generating member other than the semiconductor element include an optical pickup and a power transistor. Examples of the heat radiating member include a heatsink and a heat spreader.

As described above, by adhering a heat radiating member to a heat generating member with the copper paste, the heat generated from the heat generating member can be efficiently radiated to the outside through the heat radiating member, and the temperature of the heat generating member can be suppressed from being increased. The heat generating member and the heat radiating member may be adhered directly with the copper paste or may be adhered indirectly with a member having a high thermal conductivity intervening therebetween.

Examples

The present disclosure will be specifically shown with reference to examples below, but the present disclosure is not limited to the examples.

(Production of Copper Particles)

[Synthesis Example 1]

20 mmol of copper(II) acetate monohydrate (trade name: Copper(II) Acetate Monohydrate, produced by Tokyo Chemical Industry Co., Ltd.) as the copper compound (A), 40 mmol of hydrazinoethanol (B) (trade name: Hydroxyethylhydrazine, produced by Tokyo Chemical Industry Co., Ltd.), and 3 mL of butyl cellosolve as an organic solvent (produced by Tokyo Chemical Industry Co., Ltd.) were placed in a 50 mL sample jar, and agitated at 100°C for 120 minutes in an aluminum block type heating and agitating device. After 5 minutes, 2 mL of ethanol (guaranteed reagent, produced by KANTO CHEMICAL CO., INC.) was added, and a solid matter was obtained through centrifugal separation (4,000 rpm (1 minute)). The solid matter obtained through centrifugal separation was dried under reduced pressure, so as to provide copper particles 1 in a powder form having copper gloss having a surface protected with hydrazinoethanol (average particle diameter: 120 nm, yield amount: 1.25 g, yield: 98.0%).

[Synthesis Example 2]

40 mmol of nonanoic acid (trade name: Nonanoic Acid, produced by Tokyo Chemical Industry Co., Ltd.) and 40 mmol of hydrazinoethanol (trade name: Hydroxyethylhydrazine, produced by Tokyo Chemical Industry Co., Ltd.) were placed in a 50 mL sample jar, and agitated at 60°C for 15 minutes, so as to synthesize hydrazinoethanol nonanoate (B). Thereafter, 40 mmol of the resulting hydrazinoethanol nonanoate (B), 20 mmol of copper(II) acetate monohydrate (trade name: Copper(II) Acetate Monohydrate, produced by Tokyo Chemical Industry Co., Ltd.) as the copper compound (A), and 3 mL of butyl cellosolve as an organic solvent (produced by Tokyo Chemical Industry Co., Ltd.) were placed in a 50 mL sample jar, and agitated at 100°C for 120 minutes in an aluminum block type heating and agitating device. After 5 minutes, 2 mL of ethanol (guaranteed reagent, produced by KANTO CHEMICAL CO., INC.) was added, and a solid matter was obtained through centrifugal separation (4,000 rpm (1 minute)). The solid matter obtained through centrifugal separation was dried under reduced pressure, so as to provide copper particles 2 in a powder form having copper gloss having a surface protected with hydrazinoethanol nonanoate (average particle diameter: 90 nm, yield amount: 1.26 g, yield: 98.4%).

[Synthesis Example 3]

20 mmol of copper(II) acetate monohydrate (trade name: Copper(II) Acetate Monohydrate, produced by Tokyo Chemical Industry Co., Ltd.) as the copper compound (A), 40 mmol of hydrazinoethanol (B) (trade name: Hydroxyethylhydrazine, produced by Tokyo Chemical Industry Co., Ltd.), and 3 mL of butyl cellosolve as an organic solvent (produced by Tokyo Chemical Industry Co., Ltd.) were placed in a 50 mL sample jar, and mixed at 25°C for 5 minutes. Subsequently, a solution obtained by dissolving 20 mmol of hydrazine monohydrate (C) (trade name: Hydrazine Monohydrate, produced by FUJIFILM Wako Pure Chemical Corporation) in 3 mL of 1-propanol was added to the resulting mixture, and mixed at 25°C for 4 hours in an aluminum block type heating and agitating device. The temperature was then increased to 100°C, and the mixture was mixed for 1 hour, so as to provide copper particles 3 in a powder form having copper gloss having a surface protected with hydrazinoethanol (average particle diameter: 140 nm, yield amount: 1.24 g, yield: 96.9%).

[Synthesis Example 4]

40 mmol of nonanoic acid (trade name: Nonanoic Acid, produced by T Tokyo Chemical Industry Co., Ltd.) and 40 mmol of hydrazinoethanol (trade name: Hydroxyethylhydrazine, produced by Tokyo Chemical Industry Co., Ltd.) were placed in a 50 mL sample jar, and agitated at 60°C for 15 minutes, so as to synthesize hydrazinoethanol nonanoate (B). Thereafter, 40 mmol of the resulting hydrazinoethanol nonanoate (B), 20 mmol of copper(II) acetate monohydrate (trade name: Copper(II) Acetate Monohydrate, produced by Tokyo Chemical Industry Co., Ltd.) as the copper compound (A), and 3 mL of butyl cellosolve as an organic solvent (produced by Tokyo Chemical Industry Co., Ltd.) were placed in a 50 mL sample jar, and mixed at 25°C for 5 minutes. Subsequently, a solution obtained by dissolving 20 mmol of hydrazine monohydrate (C) (trade name: Hydrazine Monohydrate, produced by FUJIFILM Wako Pure Chemical Corporation) in 3 mL of 1-propanol was added to the resulting mixture, and mixed at 25°C for 4 hours in an aluminum block type heating and agitating device. The temperature was then increased to 100°C, and the mixture was mixed for 1 hour, so as to provide copper particles 4 in a powder form having copper gloss having a surface protected with hydrazinoethanol nonanoate (average particle diameter: 90 nm, yield amount: 1.25 g, yield: 97.7%).

[Synthesis Example 5]

The same procedure as in Synthesis Example 3 was performed except that 40 mmol of octylamine (trade name: n-Octylamine, produced by Tokyo Chemical Industry Co., Ltd.) was used instead of hydrazinoethanol (B), so as to provide copper particles 5 in a powder form having copper gloss (average particle diameter: 90 nm, yield amount: 1.25 g, yield: 97.8%).

The average particle diameters of the copper particles 1 to 5 each were a value that was calculated as an average value of 10 copper particles (n = 10) randomly selected based on the observation image with a scanning electron microscope (trade name: S-3400NX, produced by Hitachi High-Technologies Corporation).

Table 1

| | | Unit | Synthesis Example 1 | Synthesis Example 2 | Synthesis Example 3 | Synthesis Example 4 | Synthesis Example 5 |
|---|---|---|---|---|---|---|---|
| | | | Copper particles 1 | Copper particles 2 | Copper particles 3 | Copper particles 4 | Copper particles 5 |
| (A) Copper compound | Copper(II) acetate monohydrate | mmol | 20 | 20 | 20 | 20 | 20 |
| (B) Hydrazinoethanol | | mmol | 40 | - | 40 | - | - |
| (B) Hydrazinoethanol nonanoate | | mmol | - | 40 | - | 40 | - |
| (C) Hydrazine monohydrate | | mmol | - | - | 20 | 20 | 20 |
| Alkylamine | Octylamine | mmol | - | - | - | - | 40 |

(Example 1)

100 parts by mass of the copper particles 1 obtained in Synthesis Example 1 and 15 parts by mass of diethylene glycol as an organic solvent (produced by Tokyo Chemical Industry Co., Ltd.) were kneaded with rolls, so as to prepare a copper paste.

(Examples 2 to 4 and Comparative Example 1)

The same procedure as in Example 1 was performed except that the components were changed to the kinds and the amounts shown in Table 2, so as to provide copper pastes.
The copper pastes obtained in Examples and Comparative Example were evaluated by the following manner. The results are shown in Table 2.

<Evaluation Method of Copper Paste>

[Viscosity]

The value at 25°C and 5 rpm was measured with an E-type viscometer (trade name: Viscometer-TV22, produced by Toki Sangyo Co., Ltd., applied cone plate type rotor: 3° × R17.65).

[Pot Life]

The viscosity of the copper paste allowed to stand in a thermostat chamber at 25°C was measured, and the number of days by the viscosity was increased to 1.5 times or more the value measured in the section [Viscosity] above (i.e., the initial viscosity) was measured.

[Oxidation Resistance]

The resulting copper paste was subjected to X-ray diffractometry (XRD) in a nitrogen atmosphere under condition of a temperature increased from room temperature (25°C) to 300°C by 3°C/min, so as to provide XRD profiles at 25°C, 150°C, and 200°C. The contents of the components of Cu, CuO, $Cu_2O$ were quantitatively determined from the integral intensity ratios of the maximum intensity peaks of the components by the RIR (reference intensity ratio) method, and the oxidation degree was calculated according to the following expression (1).

$$\text{Oxidation degree (\%)} = ([CuO]+[Cu_2O])/([Cu]+[CuO]+[Cu_2O]) \times 100 \ldots (1)$$

In the expression (1), [Cu] represents the content of copper (Cu) (% by mass) in the copper particles, [CuO] represents the content of copper(II) oxide (% by mass) in the copper particles, and [Cu$_2$O] represents the content of copper(I) oxide (% by mass) in the copper particles.

[Sinterability]

The copper paste was coated on a glass substrate (thickness: 1 mm) to a thickness of 25 pm by a screen printing method, and hardened at 150°C for 60 minutes or at 200°C for 60 minutes. The resulting sintered film was measured for the electric resistance by a four-probe method with Loresta GP (trade name, produced by Mitsubishi Chemical Analytech Co., Ltd.). A specimen of less than $1.0 \times 10^{-5}$ $\Omega \cdot$m was designated as "A", a specimen of $1.0 \times 10^{-5}$ $\Omega \cdot$m to $5.0 \times 10^{-5}$ $\Omega \cdot$m was designated as "B", and a specimen exceeding $5.0 \times 10^{-5}$ $\Omega \cdot$m was designated as "C".

<Evaluation Method of Semiconductor Device>

[Bonding Strength]

A silicon chip of 2 mm $\times$ 2 mm having a gold vapor-deposited film on a bonding surface was mounted on a copper frame and PPF (copper frame plated with Ni-Pd/Au) with the copper paste, which was hardened in a nitrogen atmosphere (3% hydrogen) at 200°C for 60 minutes. After hardening and a hygroscopic treatment (85°C, relative humidity of 85%, 72 hours), the die share strength at room temperature (25°C) was measured with DAGE 4000 Plus (trade name, produced by Nordson Corporation).

<Thermal Shock Test>

A silicon chip of 2 mm $\times$ 2 mm having a gold vapor-deposited film on a bonding surface was mounted on a copper frame and PPF with the copper paste, which was hardened in a nitrogen atmosphere (3% hydrogen) at 200°C for 60 minutes. The assembly was molded with an epoxy sealant (trade name: KEG3000D), produced by Kyocera Corporation, under the following condition to provide a package, which was subjected to a hygroscopic treatment at 85°C and a relative humidity of 85% for 168 hours, and then subjected to an IR reflow treatment (260°C, 10 seconds) and a cold thermal cycle treatment (in which an operation of heating from -55°C to 150°C and then cooled to -55°C was designated as one cycle, and 1,000 cycles were performed), and the number of internal cracks occurred in the package after the treatments was observed with an acoustic microscope.
The number of specimens having cracks occurring among 5 specimens is shown in Table 2.

(Molding Condition)

    Package: 80pQFP (14 mm $\times$ 20 mm $\times$ 2 mm in thickness)
    Chip: silicon chip having gold plating on back surface
    Lead frame: PPF and copper
    Molding of sealant: 175°C, 2 minutes
    Post-mold hardening: 175°C, 8 hours

Table 2

| | | | Example 1 | Example 2 | Example 3 | Example 4 | Comparative Example 1 |
|---|---|---|---|---|---|---|---|
| Copper particles | Copper particles 1 | part by mass | 100 | - | - | - | - |
| | Copper particles 2 | part by mass | - | 100 | - | - | - |
| | Copper particles 3 | part by mass | - | - | 100 | - | - |
| | Copper particles 4 | part by mass | - | - | - | 100 | - |
| | Copper particles 5 | part by mass | - | - | - | - | 100 |
| Organic solvent | Diethylene glycol | part by mass | 15 | 15 | 15 | 15 | 15 |
| Viscosity | | Pa·s | 35 | 80 | 35 | 80 | 80 |
| Pot life | | day | >7 | >7 | >7 | >7 | >7 |
| Oxidation resistance (Reducing capability) | Oxidation degree 25°C | % | 2 | 2 | 2 | 2 | 2 |
| | Oxidation degree 150°C | % | 1 | 0 | 1 | 0 | 2 |
| | Oxidation degree 200°C | % | 0 | 0 | 0 | 0 | 2 |
| Sinterability | 150°C, 60 minutes | - | B | A | B | A | C |
| | 200°C, 60 minutes | - | A | A | A | A | C |
| Bonding strength | Cu after hardening | MPa | 42 | 48 | 39 | 56 | 31 |
| | Cu after hygroscopic treatment | MPa | 42 | 48 | 38 | 56 | 31 |
| | PPF after hardening | MPa | 46 | 49 | 45 | 58 | 34 |
| | PPF after hygroscopic treatment | MPa | 46 | 48 | 45 | 58 | 34 |
| Thermal shock test | Cu | number/ number | 0/5 | 0/5 | 0/5 | 0/5 | 0/5 |
| | PPF | number/ number | 0/5 | 0/5 | 0/5 | 0/5 | 0/5 |

As shown by the above results, the copper paste using the copper particles of the present embodiment coated with at least one kind of a nitrogen-containing compound selected from hydrazinoethanol and a hydrazinoethanol salt has a reduction capability to copper oxide in the heating process from room temperature, and thus can provide high sinterability in both the coating film state and the bonding state.

Furthermore, it has been found that the copper paste containing the copper particles of the present embodiment is excellent in circuit formability and can provide high bonding reliability. Accordingly, the use of the copper paste can provide a semiconductor device and an electric or electronic component that are further excellent reliability.

**Claims**

1. Copper particles coated with at least one kind of a nitrogen-containing compound selected from hydrazinoethanol and a hydrazinoethanol salt.

2. A method for producing the copper particles according to claim 1, comprising reducing a copper compound (A) with at least one kind of a nitrogen-containing compound selected from hydrazinoethanol and a hydrazinoethanol salt (B).

3. The method for producing the copper particles according to claim 2, the method further comprises adding hydrazine monohydrate (C).

4. A copper paste comprising the copper particles according to claim 1.

5. A semiconductor device bonded with the copper paste according to claim 4.

6. An electric or electronic component bonded with the copper paste according to claim 4.

## INTERNATIONAL SEARCH REPORT

| International application No. |
| --- |
| PCT/JP2019/047183 |

A.  CLASSIFICATION OF SUBJECT MATTER

B22F 1/02(2006.01)i

FI: B22F1/02 B

According to International Patent Classification (IPC) or to both national classification and IPC

B.  FIELDS SEARCHED

Minimum documentation searched (classification system followed by classification symbols)
B22F1/02

| Documentation searched other than minimum documentation to the extent that such documents are included in the fields searched | |
| --- | --- |
| Published examined utility model applications of Japan | 1922–1996 |
| Published unexamined utility model applications of Japan | 1971–2020 |
| Registered utility model specifications of Japan | 1996–2020 |
| Published registered utility model applications of Japan | 1994–2020 |

Electronic data base consulted during the international search (name of data base and, where practicable, search terms used)

C.  DOCUMENTS CONSIDERED TO BE RELEVANT

| Category* | Citation of document, with indication, where appropriate, of the relevant passages | Relevant to claim No. |
| --- | --- | --- |
| A | JP 2009-149918 A (TORAY INDUSTRIES, INC.) 09.07.2009 (2009-07-09) claims | 1-6 |
| A | JP 2016-145299 A (HITACHI CHEMICAL CO., LTD.) 12.08.2016 (2016-08-12) claims, paragraph [0032] | 1-6 |

☐  Further documents are listed in the continuation of Box C.  ☒  See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| 27 January 2020 (27.01.2020) | 04 February 2020 (04.02.2020) |

| Name and mailing address of the ISA/ Japan Patent Office 3-4-3, Kasumigaseki, Chiyoda-ku, Tokyo 100-8915, Japan | Authorized officer |
| --- | --- |
| | Telephone No. |

Form PCT/ISA/210 (second sheet) (January 2015)

**INTERNATIONAL SEARCH REPORT**

Information on patent family members

International application No.

PCT/JP2019/047183

| Patent Documents referred in the Report | Publication Date | Patent Family | Publication Date |
|---|---|---|---|
| JP 2009-149918 A | 09 Jul. 2009 | (Family: none) | |
| JP 2016-145299 A | 12 Aug. 2016 | (Family: none) | |

Form PCT/ISA/210 (patent family annex) (January 2015)

**EP 3 903 966 A1**

**REFERENCES CITED IN THE DESCRIPTION**

**Patent documents cited in the description**

- JP 2006086273 A
- JP 2005113059 A
- JP 2011240406 A
- JP 2016160456 A